Europäisches Patentamt

European Patent Office

Office européen des brevets

(19)

(11) Publication number: 0 054 539
B1

(12) **EUROPEAN PATENT SPECIFICATION**

(45) Date of publication of patent specification: 07.05.86

(51) Int. Cl.⁴: **H 01 L 23/36**

(21) Application number: 82200051.9

(22) Date of filing: 27.02.81

(60) Publication number of the earlier application in accordance with Art. 76 EPC: 0 035 390

(54) A semiconductor integrated circuit device with an improved heat sink.

(30) Priority: 29.02.80 JP 24689/80

(43) Date of publication of application:
23.06.82 Bulletin 82/25

(45) Publication of the grant of the patent:
07.05.86 Bulletin 86/19

(84) Designated Contracting States:
DE FR GB NL

(56) References cited:
US-A-3 406 753
US-A-4 069 498

IBM TECHNICAL DISCLOSURE BULLETIN Vol.
22, No. 6, November 1979, New York A.J.
ARNOLD "Structure for the Removal of Heat
from an Integrated Circuit Module" pages 2294
to 2296

The file contains technical information
submitted after the application was filed and
not included in this specification

(73) Proprietor: FUJITSU LIMITED
1015, Kamikodanaka Nakahara-ku
Kawasaki-shi Kanagawa 211 (JP)

(72) Inventor: Wakabayashi, Tetsushi
18-406 Asodaidanchi 861-2, Shimoaso, Tama-ku
Kawasaki-shi Kanagawa 215 (JP)
Inventor: Sakuma, Osamu
2-2-5, Edakita Midori-ku
Yokohama-shi Kanagawa 227 (JP)
Inventor: Honda, Norio 21-4, Aza Miyashita
Oaza Kamiarakuda Machikitamachi
Aizuwakamatsu-shi Fukushima 965 (JP)

(74) Representative: Abbott, Leonard Charles et al
GILL JENNINGS & EVERY 53-64 Chancery Lane
London WC2A 1HN (GB)

(56) References cited:
ELECTRONICS INTERNATIONAL Vol. 53, No.
26, 4 December 1980, New York M. MARSHALL
"Amdahl Leapfrogs IBM With Technology"
pages 41, 42

Courier Press, Leamington Spa, England.

## Description

The present invention relates to a semiconductor device, and more particularly to a semiconductor device which has a plurality of IC (Integrated Circuit) packages mounted on a mother board.

An example of a known semiconductor device with four IC packages mounted on a mother board is described in Proceedings of the Technical Program, National Electronic Packaging and Production Conference, "Ceramic Chip Carrier — The New Standard In Packaging" by M. L. Burch and B M. Hargis, Minnesota Mining and Manufacturing Company, 1977. This publication describes an arrangement in which the IC packages or chips are mounted in a row, using bonding pads to connect chip carrier assemblies to a ceramic substrate.

The IBM Technical Disclosure Bulletin, Vol. 22, No. 6, November 1979, pages 2294—2296, discloses a matrix of heat sinks overlying corresponding chips and embedded in a cap sealed to a substrate to which the chips are also connected.

Heat sinks for isolated semiconductor chips are also known (for example a cylindrical stand with a cooling fin assembly, as disclosed in U.S. Patent No. 3872683).

According to the present invention, there is provided a semiconductor device comprising: a mother board; a plurality of semiconductor elements each having a plurality of bonding pads, the semiconductor elements being mounted in a matrix on the mother board; a plurality of pin terminals extending from the mother board, the mother board having electrical interconnections to make connection to the pin terminals; and a plurality of heat sinks mounted on the respective semiconductor elements, each heat sink comprising a heat-conducting shaft arranged perpendicularly to the semiconductor elements and provided with heat-dissipating fins; and is characterized in that each semiconductor element is an IC package and forms part of a separate IC package unit which also comprises the respective heat sink, in which the heat-dissipating fins are in planes perpendicular to the axis of the shaft of the heat sink, and a base board the area of which is substantially greater than the cross-sectional area of the shaft of the heat sink and which is also in a plane perpendicular to the axis of the shaft, the IC package units being independently mounted on the mother board and the mother board comprising a multi-layer circuit through which the IC packages are connected to the pin terminals.

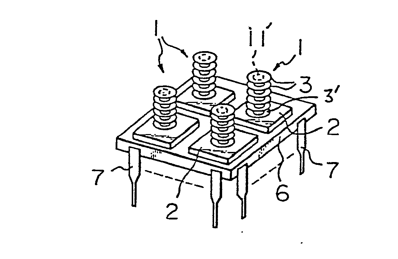

In order that the invention may be better understood, the invention will now be described with reference to the accompanying drawing which is a perspective view illustrating a semiconductor device having a multi-package structure and a heat-sink structure according to a preferred embodiment of the invention.

As illustrated in the Figure, the present embodiment of the invention comprises a square-shaped mother board 6 within which printed circuit patterns having a multilayer structure are formed. A plurality of pin terminals 7 are attached to the four edges of the mother board 6 and each of the pin terminals 7 is electrically connected to the printed circuit within the mother board 6 appropriately. On the mother board 6, four IC packages 2 are mounted. Each of the IC packages 2 contains a semiconductor element therein and has a plurality of bonding pads at the base thereof which are electrically connected to the semiconductor element. Each of the bonding pads is bonded to a corresponding one of printed circuit patterns which are formed on the mother board 6 under the bonding pads and which are connected to the printed circuit patterns formed within the mother board 6. The semiconductor device according to the present embodiment further comprises four heat sinks 1 each of which adheres to a respective one of the four IC packages 2. The heat sinks 1 which are made of materials having high thermal conductivity such as aluminum comprise a cylindrical heat conducting shaft portion 11' arranged perpendicular to the base board portion at the centre thereof. A plurality of heat dissipating fins 3 are arranged around the heat conducting shaft portion 11' at a constant distance and in parallel with each other. Each of the heat dissipating fins 3, of which the lowest 3' constitutes the base board portion, is a thin board having approximately a round shape.

The base board (i.e. the lowest fin) of each heat sink 1 may be joined to its respective IC package 2 by means of an epoxy adhesive agent, or by means of brazing, between the base board portion and the top surface of the IC package.

When the above-mentioned semiconductor device is operated, each of the IC packages 2 generates heat due to the heat generation from the semiconductor element mounted within the IC package. The heat generated from each of the IC packages 2 is transferred from the top surfaces of the IC packages 2 through the base board portion of each heat sink 1 to each heat conducting shaft 11'. Since each heat conducting shaft 11' is made of materials having high thermal conductivity, the heat conducting shaft 11' is heated up so that the temperature distribution is approximately the same throughout the whole length of the heat conducting shaft 11'. The heat delivered to the heat conducting shaft 11' is further transferred from the heat conducting shaft 11' to each of the heat dissipating fins 3 and dissipated into the surrounding air.

## Claims

1. A semiconductor device comprising: a mother board (6); a plurality of semiconductor elements (2) each having a plurality of bonding pads, the semiconductor elements being mounted in a matrix on the mother board; a plurality of pin terminals (7) extending from the mother board, the mother board having electrical interconnections to make connection to the pin terminals; and a plurality of heat sinks (1) mounted on the respective semiconductor elements, each heat sink comprising a heat-conducting shaft arranged perpendicularly to the semiconductor elements and provided with heat-dissipating fins; and characterized in that each semiconductor element is an IC package (2) and forms part of a separate IC package unit which also comprises the respective heat sink (1), in which the heat-dissipating fins (3) are in planes perpendicular to the axis of the shaft (11') of the heat sink, and a base board (3') the area of which is substantially greater than the cross-sectional area of the shaft of the heat sink and which is also in a plane perpendicular to the axis of the shaft, the IC package units being independently mounted on the mother board (6) and the mother board comprising a multi-layer circuit through which the IC packages are connected to the pin terminals (7).

2. A semiconductor device according to claim 1, including four IC packages and in which the mother board is substantially square in shape with the semiconductor devices mounted on the mother board each in a different quarter of the square, the pin terminals extending from the four sides of the mother board.

3. A semiconductor device according to claim 1 or 2, wherein the heat sinks are joined to their respective IC packages by means of an epoxy adhesive agent.

4. A semiconductor device according to claim 1 or 2, wherein the heat sinks are joined to their respective IC packages by a brazing operation between the base board portion and the top surface of the IC package.

5. A semiconductor device according to any preceding claims, wherein the heat-dissipating fins for the heat sinks are shaped as discs.

**Revendications**

1. Dispositif semiconducteur comprenant: une plaquette mère (6); plusieurs éléments semiconducteurs (2) possédant chacun plusieurs plots de liaison, les éléments semiconducteurs étant montés en une matrice sur la plaquette mère; plusieurs bornes en forme de broches (7) faisant saillie de la plaquette mère, la plaquette mère ayant des interconnexions électriques afin d'établir une connexion avec les bornes en forme de broches; et plusieurs dissipateurs de chaleur (1) montés sur les éléments semiconducteurs respectifs, chaque dissipateur de chaleur comprenant un arbre conduisant la chaleur qui est placé perpendiculairement aux éléments semiconducteurs et qui est doté d'ailettes de dissipation de chaleur;

et caractérisé en ce que chaque élément semiconducteur est un boîtier CI (2) et fait partie d'une unité de boîtier CI distincte qui comprend également le dissipateur de chaleur (1) respectif, dans lequel les ailettes (3) de dissipation de chaleur sont dans des plans perpendiculaires à l'axe de l'arbre (11') du dissipateur de chaleur, et une plaque de base (3') dont l'aire est sensiblement plus grande que l'aire en section droite de l'arbre du dissipateur de chaleur et qui est également dans un plan perpendiculaire à l'axe de l'arbre, les unités de boîtiers CI étant montées indépendamment sur la plaquette mère (6), et la plaquette mère comprenant un circuit multicouche par l'intermédiaire duquel les boîtiers CI sont connectés aux bornes en forme de broches (7).

2. Dispositif semiconducteur selon la revendication 1, comportant quatre boîtiers CI et dans lequel la plaquette mère a une forme sensiblement carrée, les dispositifs semiconducteurs montés sur la plaquette mère se trouvant chacun en un coin différent du carré, les bornes en forme de broches faisant saillie des quatre côtés de la plaquette mère.

3. Dispositif semiconducteur selon la revendication 1 ou 2, où les dissipateurs de chaleur sont liés à leurs boîtiers CI respectifs par le moyen d'un agent adhésif époxydique.

4. Dispositif semiconducteur selon la revendication 1 ou 2, où les dissipateurs de chaleur sont liés à leurs boîtiers CI respectifs par une opération de soudage entre la partie plaquette de base et la surface supérieure du boîtier CI.

5. Dispositif semiconducteur selon l'une quelconque des revendications précédentes, où les ailettes de dissipation de la chaleur du dissipateur de chaleur sont en forme de disques.

**Patentansprüche**

1. Integrierte Halbleitervorrichtung mit: einem Mutterboard (6); einer Anzahl von Halbleiterelementen (2), die jeweils eine Anzahl von Bonding-Pads haben und die in einer Matrix auf dem Mutterboard angeordnet sind; einer Anzahl von Stiftanschlüssen (7), die sich von dem Mutterboard aus erstrecken, welches elektrische Zwischenverbindungen aufweist, um die Verbindung mit den Stiftanschlüssen herzustellen; und einer Anzahl von Wärmesenken (1), die auf den entsprechenden Halbleiterelementen angeordnet sind und die jeweils einen wärmeleitenden Schaft aufweisen, der senkrecht zu den Halbleiterelementen angeordnet ist und Kühlrippen aufweist;

dadurch gekennzeichnet, daß jedes Halbleiterelement eine IC-Packung (2) ist und einen Teil einer separaten IC-Packungseinheit bildet, welche ebenfalls die entsprechende Wärmesenke (1), bei der die Kühlrippen (3) in Ebenen senkrecht zu der Achse des Schaftes (11') der Wärmesenke angeordnet sind, und ein Basisboard (3') umfaßt, dessen Fläche wesentlich größer als die Querschnittsfläche des Schaftes der Wärmesenke ist und welches ebenfalls in einer Ebene senkrecht zur Achse des Schaftes angeordnet ist, wobei die IC-Packungseinheiten unabhängig auf dem Mutterboard (6) angeordnet sind und das Mutterboard eine vielschichtige Schaltung umfaßt, durch welche die IC-Packungen mit den Stiftanschlüssen verbunden sind.

2. Halbleitervorrichtung nach Anspruch 1, mit vier IC-Packungen, und bei welcher das Mutterboard im wesentlichen eine quadratische Form hat und die Halbleitervorrichtungen jeweils in einem anderen Viertel der quadratischen Fläche des Mutterboards angeordnet sind und die Stiftanschlüsse sich von den vier Seiten des Mutterboards fort erstrecken.

3. Halbleitervorrichtung nach Anspruch 1 oder 2, bei welcher die Wärmesenke mit ihren entsprechenden IC-Packungen mittels eines Epoxy-Klebe-Agens verbunden sind.

4. Halbleitervorrichtung nach Anspruch 1 oder 2, bei welcher die Wärmesenken mit ihren entsprechenden IC-Packungen durch ein Hartlötverfahren zwischen dem Basisboardabschnitt und der oberen Oberfläche der IC-Packung verbunden sind.

5. Halbleitervorrichtung nach einem der vorhergehenden Ansprüche, bei welcher die Kühlrippen der Wärmesenken als Scheiben ausgebildet sind.